# EUROPEAN PATENT APPLICATION

(11) **EP 2 437 327 A2**
(43) Date of publication of application: **04.04.2012**
(21) Application number: 10780716.6
(22) Date of filing: 04.05.2010
(51) Int. Cl.: H01L 51/56, H05B 33/04, H01L 51/52

(54) **FABRICATION METHOD OF ORGANIC ELECTROLUMINESCENCE DISPLAY DEVICE HAVING A GETTER LAYER**

(30) Priority: 28.05.2009 KR 20090046850
(71) Applicant: Neoviewkolon Co., Ltd., Chungcheongnam-Do 350-883 (KR)
(72) Inventor: PAEK, Seung Hwan, Boryeong-si Chungcheongnam-do355-120 (KR); IM, Woo Bin, Chungcheongnam-Do 350-809 (KR); PARK, Hyun Sik, Daejeon 305-510 (KR); PARK, Jae Han, Asan-si Chungcheongnam-do 336-851 (KR); SEO, Won Kyu, Seoul 157-872 (KR)
(74) Representative: Beck & Rössig European Patent Attorneys
(86) International application number: PCT/KR2010/002840
(87) International publication number: WO 2010/137805

(57) **Abstract**

Provided herein is a method of manufacturing an organic electroluminescence display device, including the steps of: forming a getter layer on a unit sealing substrate using a dry method; providing a element substrate including a element array formed thereon, the element array including a plurality of unit organic electroluminescence devices; attaching the element substrate to the unit sealing substrate such that the getter layer faces the element array, thus forming a module; and imparting fluidity to the getter layer such that the getter layer covers upper and lateral sides of the element array. The method is advantageous in that fluidity is imparted to the getter layer, so that the upper and lateral sides of the element array is covered by the getter layer, thereby greatly improving the moisture resistance of the organic electroluminescence device.

## Description

### Technical Field

The present invention relates to a method of manufacturing an organic electroluminescence display device, and, more particularly, to a method of manufacturing an organic electroluminescence display device having a getter layer.

### Background Art

An organic electroluminescence device is a device including an anode and a cathode with an organic function film disposed therebetween. The organic function film includes an organic light-emitting layer. The recombination in the organic light-emitting layer of holes injected through the anode and electrons injected through the cathode causes the emission of light. Since such an organic electroluminescence device, unlike a liquid crystal display device, is a device that emits its own light, it has the advantage of not requiring a backlight. Further, since such an organic electroluminescence device, unlike a plasma display device, has a very low driving voltage, there is the advantage of low power consumption.

However, the organic function film is problematic in that it can be easily deteriorated by moisture. In order to solve this problem, a getter layer may be disposed in an encapsulating substrate which encapsulates the organic electroluminescence device.

### Disclosure

### Technical Problem

Accordingly, the present invention has been devised to solve the above problem, and an object of the present invention is to provide a method of manufacturing an organic electroluminescence display device having improved moisture resistance.

Objects of the present invention are not limited to the above-mentioned object, and other objects of the present invention that are not mentioned will be clearly understood by those skilled in the art from the following descriptions.

### Technical Solution

In order to accomplish the above object, an aspect of the present invention provides a method of manufacturing an organic electroluminescence display device. The method includes the steps of: forming a getter layer on a unit sealing substrate using a dry method; providing a element substrate including a element array formed thereon, the element array including a plurality of unit organic electroluminescence devices; attaching the element substrate to the unit sealing substrate such that the getter layer faces the element array, thus forming a module; and imparting fluidity to the getter layer such that the getter layer covers upper and lateral sides of the element array.

Here, the module may be heat-treated to impart fluidity to the getter layer. The getter layer may be a film containing porous nanoparticles and a polymer binder, and the heat treatment of the module may be conducted at a temperature equal to or above a glass transition temperature of the polymer binder. The heat treatment of the module may be conducted using a hot plate, a chamber or an air knife.

The forming of the getter layer may be conducted by pressing a getter film onto the unit sealing substrate or by an evaporation method. A protective film provided on at least one side of the getter film may be removed before pressing the getter film onto the unit sealing substrate. In the evaporation method, the getter layer may be formed by evaporating porous nanoparticles and monomers to deposit the evaporated porous nanoparticles and monomers on the unit sealing substrate.

The getter layer may be heat-treated before forming the module. The heat treatment of the getter layer may be conducted using a hot plate, a chamber or an air knife.

The getter layer may be an optically-transparent getter layer.

### Advantageous Effects

According to the present invention, the upper side and lateral side of the element array is covered with the getter layer by imparting fluidity to the getter layer, thus greatly improving the moisture resistance of the organic electroluminescence device.

### Description of Drawings

FIGS. 1 to 5 are schematic views sequentially showing a method of manufacturing an organic electroluminescence display device according to an embodiment of the present invention;
FIG. 6 is a schematic view showing a method of manufacturing an organic electroluminescence display device according to another embodiment of the present invention; and
FIG. 7 is a schematic view showing a method of manufacturing an organic electroluminescence display device according to still another embodiment of the present invention.

### Best Mode

Hereinafter, preferred embodiments of the present invention will be described in detail with reference to the attached drawings. However, the present invention is not limited to the following embodiments, and may be variously modified.

Those skilled in the art will appreciate that various modifications, additions and substitutions are possible, without departing from the scope and spirit of the invention as disclosed in the accompanying claims. Throughout the accompanying drawings, the same reference numerals are used to designate the same or similar components, and redundant descriptions thereof are omitted.

The objects, features and advantages of the present invention will be more clearly understood from the following detailed description and preferred embodiments taken in conjunction with the accompanying drawings. In the present specification, the terms "have", "include", "comprise" and the like are used to differentiate a certain component from other components, but the configuration of such components should not be construed to be limited by the terms. Further, in the description of the present invention, in cases where it was determined that the detailed description of the related art would obscure the gist of the present invention, the description thereof has been omitted.

The terms and words used in the present specification and claims should not be interpreted as being limited to typical meanings or dictionary definitions, but should be interpreted as having meanings and concepts relevant to the technical scope of the present invention based on the rule according to which an inventor can appropriately define the concept of the term to describe the best method he or she knows for carrying out the invention.

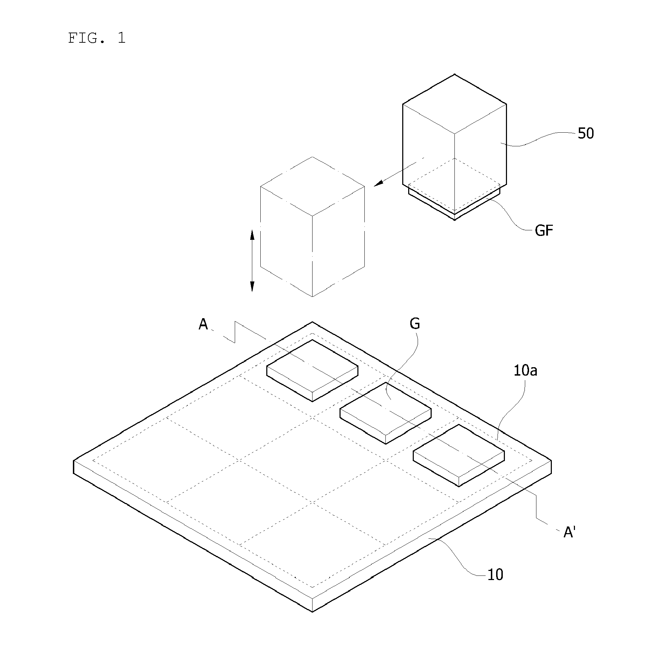

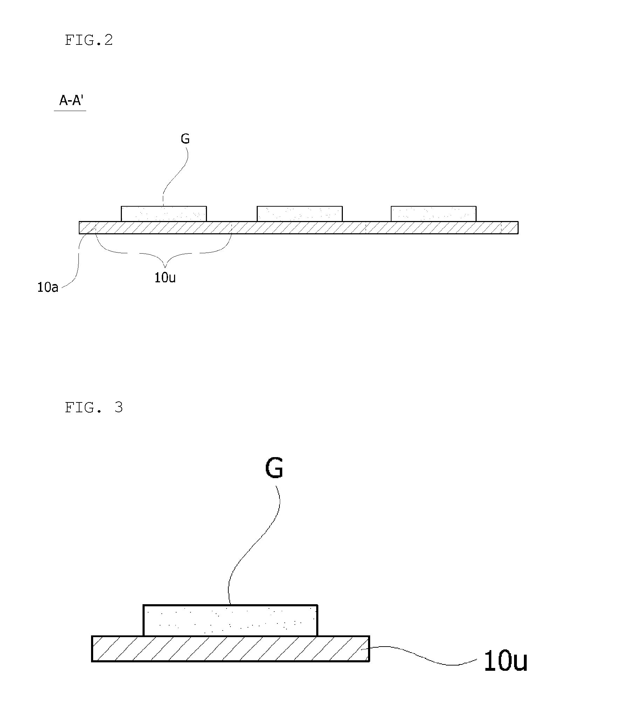

FIGS. 1 to 5 are schematic views sequentially showing a method of manufacturing an organic electroluminescence display device according to an embodiment of the present invention. Concretely, FIG. 2 is a sectional view taken along the line A-A' of FIG. 1.

Referring to FIGS. 1 and 2, a sealing substrate 10 is provided. The sealing substrate 10 includes a plurality of unit sealing substrates 10u defined by scribing lines 10a. The unit sealing substrates 10u are described so as to distinguish them from the sealing substrate 10. The sealing substrate 10 may be an optically-transparent insulation substrate, such as a glass substrate or a plastic substrate or the like.

A getter layer G is formed on each of the unit sealing substrates 10u by a dry method. The dry method is suitably used when the sealing substrate 10 is large, and can form various shapes of getter layers (G).

As an example of the dry method, the getter layer (G) can be formed by pressing a getter film (GF) onto the unit sealing substrate 10u.

The getter film (GF) may be provided on at least one side thereof with a protective film. In this case, the protective film can be removed before pressing the getter film (GF) onto the unit sealing substrate 10u.

Specifically, the getter film (GF), the upper side and lower side of which are respectively provided with an upper protective film and a lower protective film, is cut to a predetermined size, the upper side of the getter film (GF) is attached using a vacuum suction machine 50, and then the lower protective film provided on the lower side of the getter film (GF) is removed. The lower side of the getter film (GF) may be heat-treated to improve the state of the surface thereof. Thereafter, the getter film (GF) is pressed onto the unit sealing substrate 10u, thus forming the getter layer (G). In this case, the unit sealing substrate 10u or the vacuum suction machine 50 is heated to 40 ~ 100°C to improve the adhesion between the getter layer (G) and the unit sealing substrate 10u. Subsequently, the unit sealing substrate 10u is cooled to room temperature or lower, and then the upper protective film provided on the upper side of the getter layer (G) can also be removed.

A plural number of the vacuum suction machines 50 may be used in accordance with the rows of the unit sealing substrates 10u. Meanwhile, the getter layers (G) may be selectively formed on a part of the unit sealing substrates 10u, not all of the unit sealing substrates 10u.

The getter film (GF) or the getter layer (G) may be an optically-transparent getter, and may be provided with porous nanoparticles and a polymer binder. Examples of the porous nanoparticles may include metal oxides, such as alumina, silica, calcium oxide (CaO), selenium oxide (SeO) and barium oxide (BaO), and carbon compounds. When alumina, silica or a carbon compound is used as the porous nanoparticles, it exists with it chemically bonded with a polymer binder. Further, when calcium oxide (CaO), selenium oxide (SeO) or barium oxide (BaO) is used as the porous nanoparticles, acrylic resin may be employed as the polymer binder.

Subsequently, the getter layer (G) may be heat-treated. The heat-treatment of the getter layer (G) may be conducted using a hot plate, a chamber or an air knife. As a result, the moisture and solvent included in the getter layer (G) can be removed, and, moreover, the state of the surface of the getter layer (G) can be improved.

Thereafter, the getter layer (G) is cooled to solidify.

Referring to FIG. 3, the sealing substrate 10 is cut along scribing lines 10a to be separated into the unit sealing substrates 10u.

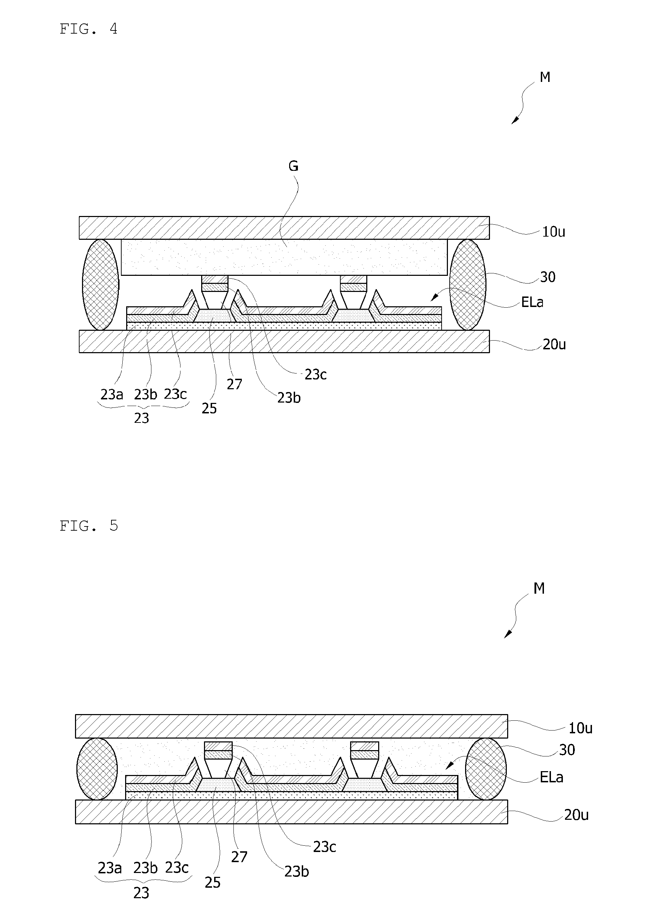

Referring to FIG. 4, there is provided a element substrate 20u on which a element array (ELa) including a plurality of unit organic electroluminescence devices 23 is formed.

The unit organic electroluminescence device includes a lower electrode 23a, an upper electrode 23c and an organic function film 23b disposed between these electrodes 23a and 23c. The organic function film 23b may include at least one organic light-emitting layer, the lower electrode 23a may be an anode, and the upper electrode 23c may be a cathode. In this case, the organic function film 23b may further include a hole injecting layer and/or a hole transport layer between the lower electrode 23a and the organic light-emitting layer, and may further include an electron injecting layer and/or an electron transport layer between the organic light-emitting layer and the upper electrode 23c.

Of these electrodes 23a and 23c, the upper electrode 23c may be at least an optically-transparent electrode. When the upper electrode 23c is a cathode, it may be a Mg-Ag film or an ITO film having a thickness through which light can be transmitted. Considering the difference in the work function between the lower electrode 23a and the upper electrode 23c, when the upper electrode 23c, which is the cathode, is an Mg-Ag film, the lower electrode 23a, which is the anode, may be an ITO film. Further, when the upper electrode 23c, which is the cathode, is an ITO film, the lower electrode 23a, which is the anode, may be a gold (Au) film or a platinum (Pt) film.

The process of forming the element array (ELa) on the element substrate 20u is described in detail as follows. First, the lower electrode 23a extending in a first direction may be formed on the element substrate 20u. A pixel defining film 25 may be formed on the lower electrode 23a. A separation pattern 27 extending in a second direction crossing the first direction may be formed on the pixel defining film 25. The organic function film 23b and the upper electrode 23c may be sequentially formed on the lower electrode 23a. In this case, another organic function film 23b and another upper electrode 23c may also be sequentially formed on the separation pattern 27.

Subsequently, a sealant 30 is applied on the periphery of the element array (ELa). The unit sealing substrate 10u is disposed over the element substrate 20u coated with the sealant 30 such that the getter layer G formed on the unit sealing substrate 10u faces the element substrate 20u. The unit sealing substrate 10u and the element substrate 20u are attached to each other by pressing in a vacuum to form a unit module (M). The inside of the unit module (M), that is, the space between the unit sealing substrate 10u and the element substrate 20u may be made vacuous.

Referring to FIG. 5, the upper side and lateral side of the element array (ELa) is covered with the getter layer (G) by imparting fluidity to the getter layer (G). The process of imparting fluidity to the getter layer (G) may be conducted at a normal pressure that is greater than that of a vacuum. In this case, the external pressure is higher than the pressure in the unit module (M), the inside of which is under a vacuum. Therefore, when fluidity is imparted to the getter layer (G), the distance between the unit sealing substrate 10u and the element substrate 20u decreases, and thus the getter layer (G) can cover the upper side and lateral side of the element array (ELa).

In this case, since externally-penetrated pollutants, such as moisture, etc., reach the organic function film 23b only when they pass through the getter layer (G), the getter layer (G) can sufficiently protect the organic function film 23b from the pollutants, such as moisture, etc. Consequently, the moisture resistance of the organic electroluminescence device 23 can be greatly improved. Moreover, the space among the element substrate 20u, the unit sealing substrate 10u and the sealant 30 can be filled with the getter layer (G).

The process of imparting fluidity to the getter layer (G) can be realized by heat-treating the unit module (M). In the heat treatment of the unit module (M), the heat treatment temperature may be a temperature at which the getter layer (G) can be imparted with fluidity, for example, the glass transition temperature (Tg) or above of a polymer binder included in the getter layer (G). However, since the organic function film 23b can be damaged during the course of heat-treating the unit module (M), it is preferable that the heat treatment of the unit module (M) be conducted at low temperature, if possible. For example, the heat treatment temperature may be 40 ~ 100°C. The heat treatment of the unit module (M) may be conducted using a hot plate, a chamber or an air knife.

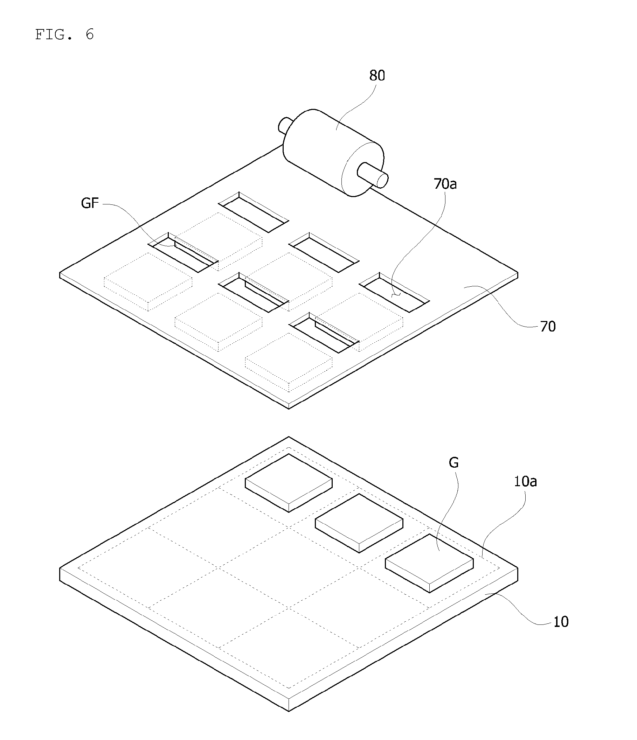

FIG. 6 is a schematic view showing a method of manufacturing an organic electroluminescence display device according to another embodiment of the present invention. The method according to this embodiment is similar to the method described with reference to FIGS. 1 to 5, except for the following description.

Referring to FIG. 6, a getter layer (G) can be formed by pressing a getter film (GF) onto the unit sealing substrate 10u. Concretely, the getter film (GF) may be disposed beneath a base film 70. The base film 70 can separate the getter layers (G) such that each of the getter layers (G) corresponds to each of the unit sealing substrates 10u because the base film 70 is provided with through-holes 70a.

A protective film may be provided on the lower side of the getter film (GF). In this case, the protective film can be removed before pressing the getter film (GF) onto the unit sealing substrate 10u. The lower side of the getter film (GF) may be heat-treated to improve the state of the surface thereof.

Thereafter, the upper side of the base film 70 is pressed using a pressing machine, for example, a roller 80, thus forming the getter layer (G). In this case, the unit sealing substrate 10u or the roller 80 is heated to 40 ~ 100°C to improve adhesion between the getter layer (G) and the unit sealing substrate 10u. Subsequently, the unit sealing substrate 10u is cooled to room temperature or lower, and then the base film 70 disposed on the upper side of the getter layer (G) can be removed.

A plural number of the rollers 80 may be used in accordance with the rows of the unit sealing substrates 10u. Meanwhile, the getter layers (G) may be selectively formed on a part of the unit sealing substrates 10u, not all of the unit sealing substrates 10u.

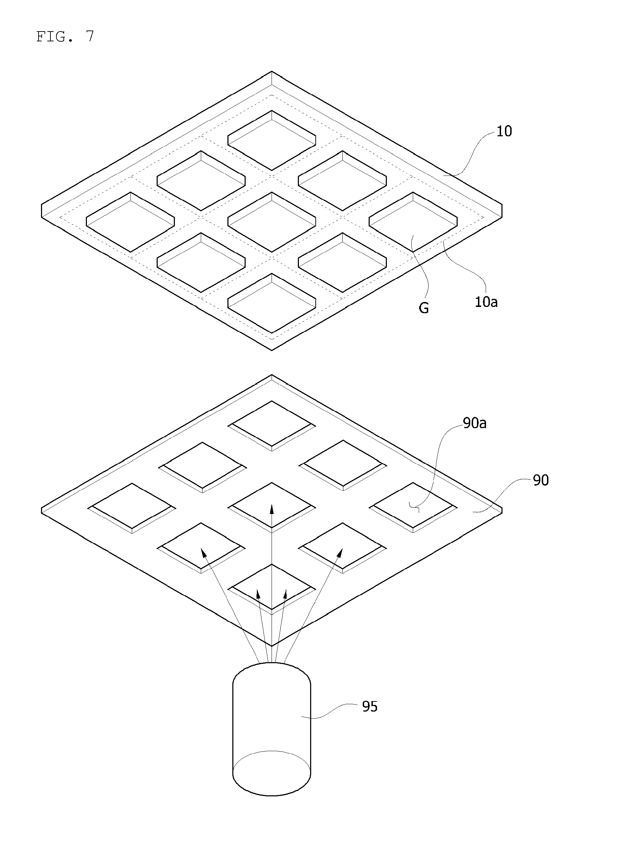

FIG. 7 is a schematic view showing a method of manufacturing an organic electroluminescence display device according to still another embodiment of the present invention. The method according to this embodiment is similar to the method described with reference to FIGS. 1 to 5, except for the following description.

Referring to FIG. 7, a getter layer (G) may be formed by an evaporation method, for example, vapor deposition polymerization or the like. Concretely, a crucible 95, in which porous nanoparticles and monomers are stored, is heated to evaporate the porous nanoparticles and monomers, and thus the evaporated porous nanoparticles and monomers are deposited on the unit sealing substrate 10u, thus forming the getter layer (G). In this case, each of the getter layers (G) can be formed on each of the unit sealing substrates 10u corresponding to each of the getter layers (G) using a shadow mask 90. In this procedure, the monomers are polymerized into a polymer binder. If necessary, a polymerization initiator is stored in the crucible 95, and thus the polymerization initiator can be evaporated together with the porous nanoparticles and the monomers.

Examples of the porous nanoparticles may include metal oxides, such as alumina, silica, calcium oxide (a0), selenium oxide (SeO) and barium oxide (BaO), and carbon compounds. When alumina, silica or a carbon compound is used for the porous nanoparticles, it is in a state of being chemically bonded with the monomers. Further, when calcium oxide (CaO), selenium oxide (SeO) or barium oxide (BaO) is used as the porous nanoparticles, metal oxides and monomers are charged in another crucible to co-evaporate the metal oxides and monomers, thus forming the getter layer (G).

The difference in thickness of the getter layers (G) can be reduced by rotating the sealing substrate 10 in the course of forming the getter layers (G).

Meanwhile, the getter layers (G) may be selectively formed on a part of the unit sealing substrates 10u, not all of the unit sealing substrates 10u. For this purpose, some of the through-holes 90a of the shadow mask 90 may be closed.

Although the preferred embodiments of the present invention have been disclosed for illustrative purposes, simple modifications, additions and substitutions of the present invention belong to the scope of the present invention, and the specific scope of the present invention will be clearly defined by the appended claims.

## Claims

1. A method of manufacturing an organic electroluminescence display device, comprising the steps of:
forming a getter layer on a unit sealing substrate using a dry method;
providing a element substrate including a element array formed thereon, the element array including a plurality of unit organic electroluminescence devices;
attaching the element substrate to the unit sealing substrate such that the getter layer faces the element array, thus forming a module; and
imparting fluidity to the getter layer such that the getter layer covers upper and lateral sides of the element array.

2. The method of manufacturing an organic electroluminescence display device according to claim 1, wherein the module is heat-treated to impart fluidity to the getter layer.

3. The method of manufacturing an organic electroluminescence display device according to claim 2, wherein the getter layer is a film containing porous nanoparticles and a polymer binder, and the heat treatment of the module is conducted at a temperature equal to or above a glass transition temperature of the polymer binder.

4. The method of manufacturing an organic electroluminescence display device according to claim 2, wherein the heat treatment of the module is conducted using a hot plate, a chamber or an air knife.

5. The method of manufacturing an organic electroluminescence display device according to claim 1, wherein the forming of the getter layer is conducted by pressing a getter film onto the unit sealing substrate or by an evaporation method.

6. The method of manufacturing an organic electroluminescence display device according to claim 5, further comprising the step of removing a protective film provided on at least one side of the getter film before pressing the getter film onto the unit sealing substrate.

7. The method of manufacturing an organic electroluminescence display device according to claim 5, wherein, in the evaporation method, the getter layer is formed by evaporating porous nanoparticles and monomers to deposit the evaporated porous nanoparticles and monomers on the unit sealing substrate.

8. The method of manufacturing an organic electroluminescence display device according to claim 1, further comprising the step of heat-treating the getter layer before forming the module.

9. The method of manufacturing an organic electroluminescence display device according to claim 8, wherein the heat treatment of the getter layer is conducted using a hot plate, a chamber or an air knife.

10. The method of manufacturing an organic electroluminescence display device according to claim 1, wherein the getter layer is an optically-transparent getter layer.
